# EUROPÄISCHE PATENTSCHRIFT

(11) **EP 2 532 084 B1**
(45) Veröffentlichungstag und Bekanntmachung des Hinweises auf die Patenterteilung: **04.01.2017**
(21) Anmeldenummer: 11702935.5
(22) Anmeldetag: 28.01.2011
(51) Int. Cl.: H02M 7/00

(54) **ELEKTRONISCHE BAUGRUPPE ZUM SCHALTEN ELEKTRISCHER LEISTUNG**
ELECTRONIC SUBASSEMBLY FOR SWITCHING ELECTRIC POWER
COMPOSANT ÉLECTRONIQUE POUR COMMUTER UNE PUISSANCE ÉLECTRIQUE

(30) Priorität: 04.02.2010 DE 102010006850
(43) Veröffentlichungstag der Anmeldung: 12.12.2012
(73) Patentinhaber: Compact Dynamics GmbH, 82319 Starnberg (DE)
(72) Erfinder: GRUENDL, Andreas, 82319 Starnberg (DE); HOFFMANN, Bernhard, 82319 Starnberg (DE); KLEIMEIER, Alexander, 84030 Landshut (DE)
(74) Vertreter: Schmidt, Steffen
(86) Internationale Anmeldenummer: PCT/EP2011/000406
(87) Internationale Veröffentlichungsnummer: WO 2011/095309

(56) Entgegenhaltungen:
- DE-A1- 10 109 548
- DE-A1- 10 326 321
- DE-A1- 19 725 836
- US-A- 5 142 439
- US-A- 5 747 875
- US-A1- 2005 068 820

## Beschreibung

### Hintergrund

Vorgestellt wird eine elektronische Baugruppe zum Schalten elektrischer Leistung. Solche elektronischen Baugruppen können zum Beispiel als Halbbrückenschaltung ausgestaltet sein um Wechselrichter oder Frequenzumrichter für die unterschiedlichsten Anwendungsbereiche zu realisieren. Dazu gehören elektronische Baugruppen zum Betreiben von Synchron-, Asynchron-, Reluktanzmaschinen, permanent erregten Maschinen oder dergl. sowohl als Motoren als auch als Generatoren (siehe zum Beispiel DE-A-40 27 969 oder DE-A-42 30 510).

So beschreibt zum Beispiel die WO 2004/110123 A1 eine elektronische Baugruppe mit zwei Leistungsversorgungsschienen, einer Sammelschiene, zwischen den Leistungsversorgungsschienen angeordneten Halbleiterschaltern sowie einer über den Leistungsversorgungsschienen angeordneten und diese überbrückende Kondensatoranordnung.

### Stand der Technik

Es ist bekannt, elektrische Maschinen, insbesondere Wechselfeldmaschinen, mit Frequenzumrichtern zu betreiben. Üblicherweise enthält ein solcher Frequenzumrichter eine der Anzahl der Phasen der daran angeschlossenen elektrischen Maschine entsprechende Anzahl von Halbbrückenanordnungen, die von einer Ansteuerelektronik mit Steuersignalen gespeist wird. Damit wird - je nach dem ob die elektrische Maschine als Motor oder als Generator betrieben wird - die elektrische Leistung der elektrischen Maschine entweder für die gewünschte Drehzahl und das gewünschte Drehmoment zugeführt, oder der elektrischen Maschine wird die elektrische Leistung entnommen und für den nachgeschalteten Verbraucher in die gewünschte Betrags- und Phasenlage umgesetzt.

Insbesondere bei schnell schaltenden Frequenzumrichtern oder Wechselrichtern treten dabei an den Schaltflanken der zu- bzw. abgeführten elektrischen Leistung hohe Über- oder Unterschwing-Impuls-Spannungsspitzen auf. Die Spannungsfestigkeit der in der elektronischen Baugruppe eingesetzten Halbleiterschalter muss aufgrund der auftretenden Überspannungs-Impulse erheblich höher sein als deren Betriebsspannuwlgsfestigkeit. Dies erhöht die Kosten der Baugruppe nennenswert.

Die DE 198 26 731 zeigt ein Beispiel für eine Halbbrückenbaugruppe zum Schalten elektrischer Leistung, die in einem eine elektrisch isolierende Kühlflüssigkeit enthaltenden Gehäuse angeordnet ist. Der Aufbau dieser Halbbrückenbaugruppe hat eine kompakte Anordnung, damit das erforderliche Volumen an Kühlflüssigkeit gering gehalten werden kann.

Die US 5,671,134 zeigt eine Wechselrichtereinheit einer anderen Art, wobei jeder Schatterbauteil seine eigene Kondensatoranordnung hat, die jeweils nicht zwischen dem hohen und dem niedrigen Spannungspotential angeordnet ist.

Die US 5,493,472 zeigt eine elektronische Baugruppe, in der eine Kondensatoranordnung mit zwei Bolzen auf Leistungsversorgungsschienen montiert wird. Die zwei Bolzen werden in zwei getrennte Bohrungen der Kondensatoranordnung eingeführt, um die Kondensatoranordnung mit den Leistungsversorgungsschienen zu verbinden. Die Kondensatoranordnung weist zwei Wicklungen auf, die durch die Leitungen miteinander und mit den Leistungsversorgungsschienen über die Bolzen verbunden sind.

In US 6,249,448 wird ein elektronisches Leistungsgerät beschrieben, bei dem die Kondensatoren in Gruppen zwischen den Leistungsschienen angeordnet sind. Die verwendeten Schalter sind parallel angeordnet.

Die DE 199 10 787 A1 beschreibt einen Umformer für einen Drehstrommotor in Flurförderfahrzeugen, bei dem Leistungstransistoren zur Erzeugung einer dreiphasigen Ausgangswechselspannung jeweils in den Zweigen einer Brücke zwischen einer positiven und einer negativen Gleichspannung betrieben werden und die Phasenwechselspannungen an jeweils einer Stromschiene abnehmbar sind. Ferner sind die Transistoren an einem Kühlkörper angebracht und eine Kondensatorbatterie ist an die Gleichspannungspotentiale angeschossen.

Die DE 298 19 349 U1 beschreibt eine Halbleiter-Schaltungsanordnung, insbesondere einen Hochstromumrichter mit niedriger Zwischenkreisspannung. Dabei ist eine erste Anordnungsebene mit einer Leistungseinheit und eine über der ersten Anordnungsebene angeordnete zweite Anordnungsebene mit Zwischenkreis-Bauelementen vorgesehen.

### Zugrunde liegendes Problem

Die hier vorgestellte Baugruppe soll gegenüber dem oben zitierten Stand der Technik in ihren Betriebseigenschaften verbessert sein, kostengünstig herstellbar sein und kompakt bauen. Damit wäre sie auch für mobile Anwendungen (zum Beispiel im Automobilbereich) einsetzbar.

### Lösung

Zur Lösung ist eine elektronische Baugruppe zum Schalten elektrischer Leistung vorgesehen, mit zwei voneinander beabstandeten Leiterschienen, zwischen denen mittels eines Steuereingangs anzusteuernde Halbleiterschalter zum Bereitstellen der elektrischen Leistung über eine Sammelschiene an einem Leistungsausgang angeordnet sind. Zumindest eine Leiterbahn ist vorgesehen, die ein von dem elektrischen Potential der Leiterschfenen abweichendes elektrisches Potential aufweist. Zwischen den beiden Leiterschienen ist eine Kondensatoranordnung angeordnet. Die Halbleiterschalter und die Leiterschienen und die Sammelschiene sind mit an einem Substrat aufgebrachten elektrischen Leitern verbunden. Das Substrat hat im Bereich wenigstens zweier seiner Ränder jeweils elektrische Leiter, die im wesentlichen miteinander übereinstimmende elektrische Potentiale führen. Die Halbleiterschalter, die Leiterschienen, die Last-/ Sammelschiene, und / oder die Kondensatoranordnung sind an einer Seite des Substrates angeordnet und das Substrat hat an der anderen Seite eine mit den Leiterschienen elektrisch verbundene Potentialleitung(sfläche). Die Leiter können sowohl Leitungen ans auch Leitungsflächen sowie Leiterschienen und Last-/Sammelschienen umfassen.

### Vorteile, Varianten und Ausgestaltungen

Dieser Aufbau erlaubt, die unterschiedliches elektrisches Potential führenden Leiter kapazitiv mit sehr geringer parasitärer Induktivität zu verbinden. Außerdem kann auf diese Weise eine besonders kompakte Anordnung erreicht werden, die eine mit bisherigen Lösungen nicht vergleichbare Packungsdichte ermöglicht. Außerdem sind Spannungs-Impulsspitzen selbst beim Schalten mit Pulszeiten im Bereich von bis zu 10 - 1000 nsec und hohen Schaltleistungen im Bereich von mehreren 10 Watt bis zu mehreren Kilowatt erheblich minimierbar. Dies führt zu einer erheblich erhöhten Störsicherheit. Durch die beschriebene Anordnung sind die elektrische Leistung führenden Leitungen zu / von den Halbleiterschaltern und den als Stützkondensator wirkenden Kondensatoranordnungen sehr niederinduktiv. Ein weiterer wesentlicher Vorteil ist der modulare Aufbau der Baugruppe, der eine problemlose Erweiterung und Anpassung der elektronischen Baugruppe an die jeweiligen Anforderungen erlaubt.

Die Anordnung erlaubt auch, eine sehr kleine Ausschaltüberspannung zu erreichen. Damit wird die Halbleiter-Sperrspannung besser ausgenutzt. Weiterhin ist ein sehr flacher Aufbau möglich, der sowohl mit gebondeten sog. dies (engl.= ungehäusten Halbleitern), als auch mit gehäusten Standard-Halbleiterbauelementen (zum Beispiel in TO-Gehäusen) ausgeführt werden kann.

Auch ist eine einfache Bestückung mit Chip-Folienkondensatoren möglich. Der Einsatz von direct copper bonded (DCB) Substrat hat ebenfalls eine Reihe von Vorteilen. DCB Substrate haben einen Isolator zum Beispiel aus Keramik, zum Beispiel aus Al₂O₃ (Aluminiumoxid) oder AIN (Aluminiumnitrid), auf dem in einem Hochtemperaturschmelz- und Diffusionsprozess zum Beispiel reines Kupfer aufgebracht und haftfest mit dem keramischen Isolator verbunden wird.

Vor allem die hohe Wärmeleitfähigkeit von Al₂O₃ (24 W/mK) und AIN (130 bis 180 - W/mK) sowie die hohe Wärmekapazität und Wärmespreizung einer Kupferbeschichtung, die mit 100 bis 900 µm auch relativ dick ausgestaltet sein kann, sind für diese Leistungselektronik-Baugruppe sehr vorteilhaft. Die mechanische Stressbelastung der zum Beispiel ungehäust aufgebrachten Siliziumchips ist gering, da der Wärmeausdehnungskoeffizient mit 7,1 ppm/K bei Al₂O₃ und 4,1 ppm/K bei AIN dem des Siliziums (4 ppm/K) der Leistungs-Halbleiterschalter besser angepasst ist, als jener von Substraten auf Metall- oder Kunststoffbasis.

Als Substrat kann auch Siliziumkarbid oder -nitrid eingesetzt werden. Alternativ dazu kann auch ein Aluminiumsubstrat verwendet werden das auf beiden Flächen jeweils eine Isolierschicht, zum Beispiel Glas, trägt. Auf den Isolierschichten ist jeweils eine Lage aus Kupfer oder einem anderen elektrischen Leiter, zum Beispiel Aluminium, aufgebracht. Anstelle der vorstehend genannten Varianten für das Substrat kann auch ein organischer Kunststoff eingesetzt werden. Dieser Kunststoff kann ein Material oder mehrere Materialien der Gruppe Polyethylen (PE), Polyvinylehlorid (PVC), Polyethylenterephthalat (PET) oder Glykol-modifiziertes Polyethylenterephthalat (PETG), Polyethylennaphthalat (PEN), Acrylnitril-Butadien-Styrol-Copolymerisat (ABS), Polyvinylbutyral (PVB), Polymethylmethacrylät (PMMA), Polyimid (PI), Polyvinylalkohol (PVA), Polystyrol (PS), Polyvinylphenol (PVP), Polypropylen (PP), Polycarbonat (PC) oder deren Derivate enthalten.

Die Verwendung von hochreinem Kupfer als Leitungs- und Kontaktmetall bietet eine sehr hohe Stromtragfähigkeit. Die Kupferoberflächen können chemisch mit Nickel und Nickel/Gold veredelt sowie mit Lötstopplack versehen sein.

Die Unterseite des DCB Substrates wird zur Kontaktierung der Minusschiene benutzt. Der vorliegende Aufbau erlaubt ein schnelles Schalten zur Minimierung der Schaltverluste. Hier können typischerweise 100 bis 200ns pro Schaltvorgang erreicht werden. Der strukturelle Aufbau ist sowohl für MOSFET-Wethselrichter als auch für IGBT-Wechselrichter geeignet.

Da die Kondensatoranordnungen einerseits räumlich und elektrisch sehr dicht bei den Kontaktflächen und andererseits auch räumlich und elektrisch sehr dicht bei den Halbleiterschaltern positioniert sind, sind praktisch kaum Leitungsabschnitte vorhanden, welche nennenswerte störende induktive Anteile hervorrufen. Außerdem ist der Raum zwischen dem Massepotential und den Strom führenden Leitungen und Bauteilen minimal. Damit sind sehr kurze Schaltzeiten realisierbar. Effektiv hängt durch diese Ausgestaltung der induktive parasitäre. Anteil wesentlich von der Dicke des Substrates ab, auf dessen einer Seite sich das Massepotential und auf dessen anderer Seite die Strom führenden Leitungen befinden.

Diese kurzen Schaltzeiten werden noch dadurch begünstigt, dass bei mehreren nebeneinander angeordneten erfindungsgemäßen Baugruppen die Kondensatoranordnungen und die geringen Leitungsinduktivitäten einer Baugruppe dazu beitragen, etwaige Störimpulse benachbarter Baugruppen (Übersprechen) zu vermeiden.

Die / jede oder einige der Kondensatoranordnungen kann zwischen einer der Leiterschienen und der Sammelschiene angeordnet sein.

Eine der Leiterschienen kann zur anderen der Leiterschienen und / oder zur Sammelschiene im wesentlichen parallel angeordnet sein.

Die Kondensatoranordnung und die Leiterschienen und die Sammelschiene könnten relativ zueinander so dimensioniert sein, dass die Kondensatoranordnung die Leiterschienen und die Sammelschiene um nicht mehr als etwa 20 % bis etwa 30 % der Höhe der Kondensatoranordnung überragt.

Die Potentialleitung(sfläche) kann eine Kühleinrichtung kontaktieren oder mit dieser integral ausgebildet sein.

Die Halbleiterschalter und mit den Halbleiterschaltern verbundene elektrische oder elektronische Bauteile können so miteinander verschaltet sein, dass sie zwischen einer durch die Potentialleitung(sfläche) definierten Ebene und einer durch eine von der Potentialleitung(sfläche) abliegenden Seite der Leiterschienen und der Sammelschiene definierten Ebene angeordnet sind.

Bei einer bevorzugten Ausführungsform sind die Halbleiterschalter durch FeldeffektTransistoren (FETs) oder durch bipolare Transistoren mit isoliertem Gate-Anschluss (IGBTs) gebildet. Dabei können insbesondere MOS-FETs mit integrierten Freilaufdioden oder zu den Transistoren parallel geschaltete zusätzliche externe Freilaufdioden eingesetzt werden. Diese externen Freilaufdioden sind vorteilhaft in gleicher Weise wie die Halbleiterschalter und in unmittelbarer Nähe zu diesen bei einer der Leiterschienen angeordnet.

Die Halbleiter können großflächige Kontaktierungsstellen mit einer Edelmetall-Auflage haben. Damit können sie mit mehreren nebeneinander angeordneten Kontaktdrähten (zum Beispiel Bonddrähten) elektrisch mit den Leiter(fläche)n / Leiterschienen / der Sammelschiene verbunden werden.

An einer von der Potentialleitungsfläche abliegenden Seite einer oder beider der Leiterschienen kann eine Baugruppe mit einem elektrischen Zwischenkreis zur Kopplung der Halbbrücken angeordnet sein, wobei der Zwischenkreis weitere Kondensatoren trägt.

Die Kondensatoranordnung kann Folienkondensatoren haben. Diese tragen zur Realisierung eines niederinduktiven Kommütierungskreises bei.

Die elektronische Baugruppe kann einen gedachten Querschnitt aufweisen, der die beiden Halbleiterschalter eines Halbleiterschalterpaares schneidet. Bei diesem gedachten Querschnitt kann eine erste gedachte Querschnittsfläche geringer als etwa die Hälfte einer zweiten gedachten Querschnittsfläche sein, wobei die erste gedachte Querschnittsfläche durch die Leitungsflächen welche ein vom Potential der Potentialleitungsfläche unterschiedliches elektrisches Potential führen und der Potentialleitungsfläche begrenzt ist, und die zweite gedachte Querschnittsfläche durch die Potentialleitungsfläche und eine durch die auf dem Substrat aufliegende Seite der Leiterschienen definierte Ebene begrenzt ist.

Diese Maßnahme verringert die Induktivität zwischen den Leiterschienen (Plusschiene und / oder Minusschiene) und der Sammelschiene auf ein minimal mögliches Maß. Somit sind auch die Störungen minimiert.

Die beiden Leiterschienen und die Sammelschiene können durch das elektrisch isolierende Substrat mechanisch miteinander fest verbunden sein. Das Substrat kann auch zur Aufnahme von Leiterbahnen dienen, um den Halbleitern Steuersignale zuzuführen, um weitere aktive oder passive Bauelemente aufzunehmen, oder um Test- oder Mess-Stellen aus der Baugruppe herauszuführen. Das Substrat kann auch dazu dienen, Verbindungsleitungen zwischen den jeweiligen Steuereingängen der Halbleiterschalter und dem Anschluss zur Verbindung mit der Ansteuereinrichtung aufzunehmen.

Das Substrat kann mit Aussparungen versehen sein, die so bemessen sind, dass die auf den Leiterschienen oder dem Substrat direkt aufgebrachten Halbleiter (Transistoren und Dioden) zumindest mit ihren Kontaktierungsstellen freiliegen. So addieren sich die effektive Bauhöhe der Halbleiter und des Substrates nicht. Vielmehr können die Halbleiter mit den Leiterschienen zumindest mit einigen ihrer Anschluss-Stellen direkt und auf gleichem Niveau verbunden sein. Das Substrat dient damit sowohl der mechanischen Verbindung der Leiterschienen untereinander als auch der elektrischen Leitungsführung.

Das Substrat kann strombegrenzende Widerstände in den Ansteuerleitungen für die Halbleiterschalter tragen, wobei diese (Gate-)Widerstände zwischen den jeweiligen Steuereingängen und dem Anschluss zur Verbindung mit der Ansteuereinrichtung vorgesehen sind.

Die elektronische Baugruppe kann wenigstens zwei Halbleiterschalter haben, die unter Bildung einer Halbbrücke in Serie geschaltet sind. Jeder Halbleiterschalter hat einen Steuereingang zur Verbindung mit einer Ansteuereinrichtung. Der erste Halbleiterschalter ist mit seinem Drain-Anschluss mit einem hohen Spannungspotential zu verbinden. Der zweite Halbleiterschalter ist mit seinem Source-Anschluss mit einem niedrigen Spannungspotential zu verbinden. Zur Bildung eines Ausgangs ist der Source-Anschluss jedes ersten Halbleiterschalters mit dem Drain-Anschluss des jeweiligen zweiten Halbleiterschalters verbunden. Die wenigstens eine Kondensatoranordnung ist zwischen dem hohen und dem niedrigen Spannungspotential angeordnet. Jeweilige erste Halbleiterschalter sind mit ihrem Drain-Anschluss auf einem gemeinsamen ersten, mit dem hohen Spannungspotential zu verbindenden metallischen Leiter angeordnet. Jeweilige zweite Halbleiterschalter sind mit ihrem Drain-Anschluss auf einem gemeinsamen zweiten, den Ausgang bildenden metallischen Leiter angeordnet. Dabei ist der zweite Leiter im Abstand zum ersten Leiter neben diesem angeordnet. Jeder zweite Halbleiterschalter ist mit seinem Source-Anschluss mit einem dritten, mit dem niedrigen Spannungspotential zu verbindenden metallischen Leiter verbunden, der im Abstand zu und neben dem ersten und dem zweiten Leiter angeordnet ist.

Weitere Merkmale, Eigenschaften, Vorteile und mögliche Abwandlungen werden für einen Fachmann anhand der nachstehenden Beschreibung deutlich, in der auf die beigefügte Zeichnung Bezug genommen ist.

### Kurzbeschreibung der Zeichnung

In Fig. 1 ist ein schematischer Schaltplan einer elektronischen Baugruppe veranschaulicht.
In Fig. 2a ist eine schematische Querschnittsansicht einer Ausführung der elektronischen Baugruppe nach dem schematischen Schaltplan aus Fig. 1 entlang der Schnittlinie A - A in der Fig. 2b veranschaulicht.
In Fig. 2b ist eine schematische Draufsicht auf eine elektronische Baugruppe gemäß Fig. 2a veranschaulicht.

### Detaillierte Beschreibung der Zeichnung

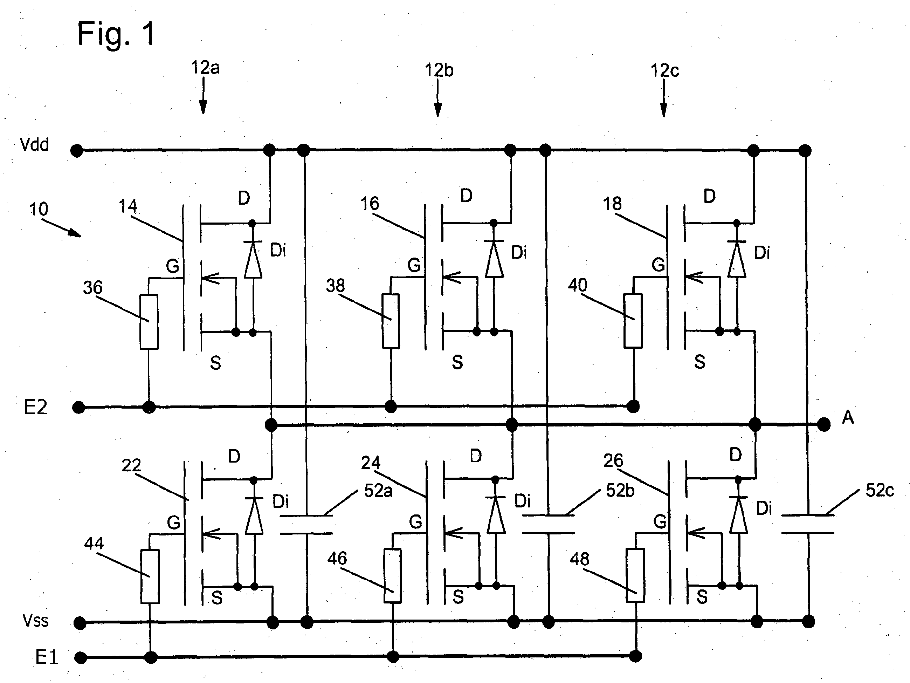

Bei der in der Fig. 1 veranschaulichten elektronischen Baugruppe 10 handelt es sich um eine Halbbrückenschaltung, die drei parallel geschaltete Paare 12a, 12 b, 12c von N-Kanal MOSFETs aufweist, die als Halbleiterschalter wirken. Jeweils zwei der MOSFETs 14, 22; 16, 24; 18, 26 die jeweils ein Paar bilden, sind in Serie geschaltet. Jeweils der erste MOSFET 14; 16; 18 jedes Paares liegt mit seinem Drain-Anschluss D auf einem hohen Spannungspotential V_{DD}, und jeder zweite MOSFET 22; 24; 26 jedes Paares liegt mit seinem Source-Anschluss S auf einem niedrigen Spannungspotential V_{SS}. Dabei sind zur Bildung eines Ausgangs A der Source-Anschluss S jedes der ersten MOSFETs 14; 16; 18 und der Drain-Anschluss D jedes der zweiten MOSFETs 22; 24; 26 miteinander verbunden.

Jeweils ein Steuereingang E1; E2 ist für die Gruppe der ersten MOSFETs 14; 16; 18 bzw. die Gruppe der zweiten MOSFETs 22; 24; 26 vorgesehen, wobei über Gatewiderstände 36; 38; 40 bzw. 44; 46; 48 die Gateanschlüsse G der jeweiligen MOS-FETs angesteuert werden. Jeder der als MOSFETs ausgestalteten Halbleiterschalter hat zwischen seinen Leistungsanschlüssen D, S eine Freilaufdiode Di, die als sog. "Body-Diode" mit dem jeweiligen Halbleiterschalter integriert auf dem gleichen Halbleiterelement ausgeführt ist. Alternativ dazu sind separate Dioden direkt neben den MOSFETs angeordnet.

Zwischen dem hohen und dem niedrigen Spannungspotential V_{DD} und V_{SS} ist eine Stützkondensatoranordnung angeordnet, die durch mehrere zueinander parallel geschaltete Stützkondensatoren 52a, 52b, 52c gebildet ist. Die Ausführung der Kondensatoranordnung ist weiter unten detaillierter beschrieben. Die Ansteuerung der jeweiligen Gruppe der MOSFETs erfolgt über die beiden Eingänge E1 und E2 mit einem zum Beispiel pulsweitenmodulierten Steuersignal von bis zu oder mehr als 100 kHz Schaltfrequenz.

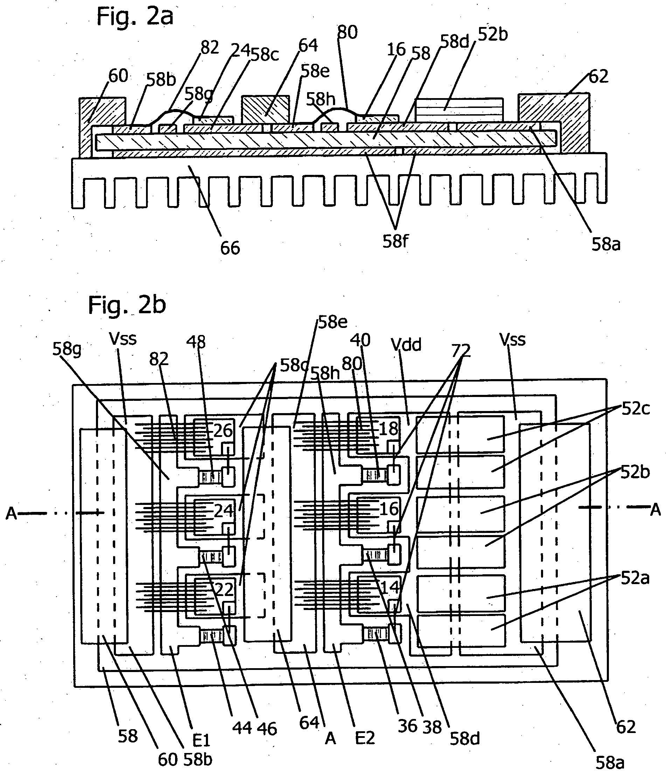

Wie in den Fig. 2a, 2b gezeigt, hat die elektronische Baugruppe 10 in der Draufsicht einen im wesentlichen rechteckigen Aufbau. Ein Substrat 58 hat im Bereich zweier seiner Ränder an den Längsseiten an seiner einen (in Fig. 2a oberen) Seite jeweils elektrische Leiter 58a, 58b, die im wesentlichen miteinander übereinstimmende elektrische Potentiale führen. Diese beiden elektrischen Leiter 58a, 58b sind jeweils von einer abgewinkelten Leiterschiene 60, 62 kontaktiert, die an den beiden Längsseiten das Substrat 58 jeweils übergreifen und zu einem Kühlkörper 66 reichen, mit dem sie verbunden sind, zum Beispiel verschraubt, vernietet, verlötet oder verschweißt. Die Leiterschienen 60, 62 und der Kühlkörper 66 führen übereinstimmendes (niedriges) Spannungspotential V_{SS}.

Zwischen den Leiterschienen 60, 62 sind die mittels der Steuereingänge E1, E2 anzusteuernden Halbleiterschalter 14, 22; 16, 24; 18, 26 zum Bereitstellen der elektrischen Leistung über eine Sammelschiene 64 angeordnet, um die elektrische Leistung aus der elektronische Baugruppe 10 herauszuführen.

Zwischen den beiden Leiterschienen 60, 62 ist die aus den Stützkondensatoren 52a, 52b, 52c gebildete Kondensatoranordnung angeordnet. Diese sind in der vorliegenden Ausführung entlang der Leiterschiene 62 angeordnet.

Die Halbleiterschalter 14, 22; 16, 24; 18, 26 und die Leiterschienen 60, 62 sowie die Sammelschiene 64 sind mit an einem Substrat 58 aufgebrachten elektrischen Leitungsflächen verbunden. Die Kondensatoranordnung überragt die Leiterschienen 60, 62 und die Sammelschiene 64 nicht. Vielmehr ist die Kondensatoranordnung durch mit den Leiterschienen 60, 62 verbundene blockförmige Folienkondensatoren 52a, 52b, 52c gebildet. Die Bauhöhe der Folienkondensatoren 52a, 52b, 52c ist geringer als die der Leiterschienen. Die Folienkondensatoren 52a, 52b, 52c sind entlang der Leiterschienen nebeneinander angeordnet.

Die Halbleiterschalter 14, 22; 16, 24; 18, 26 und die Leiterschienen 60, 62 sowie die Sammelschiene 64 und die Kondensatoranordnung sind an einer Seite (in Fig. 2a, 2b der oberen Seite) des Substrates 58 angeordnet. An der anderen Seite (in Fig. 2a, 2b der unteren Seite) hat das Substrat 58 eine mit den Leiterschienen 60, 62 elektrisch verbundene Potentialleitungsfläche 58f. Diese Potentialleitungsfläche 58f an der Unterseite des Substrats 58 kann wie dargestellt auch mehrteilig sein. Sie steht mit dem Kühlkörper 66 in elektrischem und thermischem Kontakt und führt ebenfalls das elektrische Potential der Leiterschienen 60, 62.

Die ersten MOSFETs 14; 16; 18 sind mit ihrem Drain-Anschluss D mit einer gemeinsamen ersten, mit dem hohen Spannungspotential V_{DD} zu verbindenden metallischen Leiterbahn 58d elektrisch verbunden. Die Leiterbahn 58d ist ebenfalls aus Kupfer oder einem elektrischen Strom und Wärme ähnlich gut leitenden Material hergestellt und befindet sich wie alle anderen Leiterbahnen 58... auf dem Substrat 58. In einem nicht dargestellten Ausführungsbeispiel kann auf der Leiterbahn 58d ebenfalls eine Leiterschiene angeordnet sein. Zusätzlich oder alternativ dazu können auch elektrisch leitende Distanzbolzen vorgesehen sein.

Die zweiten MOSFETs 22; 24; 26 sind mit ihrem Drain-Anschluss D durch mtallische Leiterbahnen 58c mit der den Ausgang A bildenden metallischen Sammelschiene 64 elektrisch verbunden, wobei die Sammelschiene 64 im Abstand zur ersten und zur zweiten Leiterschiene 60, 62 zwischen diesen angeordnet ist. Die Sammelschiene 64 hat ein im Querschnitt etwa rechteckiges Profil und ist aus dem gleichen Material wie die ersten und zweiten Leiterschienen 60, 62 gebildet.

Die zweiten MOSFETs 22; 24; 26 sind über mehrere Bonddrähte 82 oder andere zur Stromführung dienende Verbinder jeweils mit ihren Source-Anschlüssen S mit der gemeinsamen, mit dem niedrigen Spannungspotential V_{SS} zu verbindenden metallischen Leiterschiene 60 verbunden, wobei die Leiterschiene 60 im Abstand zu und neben der Sammelschiene 64 angeordnet ist.

Ähnlich wie die zweiten MOSFETs sind die ersten MOSFETs 14; 16; 18 über mehrere Bonddrähte 80 oder andere zur Stromführung dienende Verbinder jeweils mit ihren Source-Anschlüssen S mit der Sammelschiene 64 verbunden.

Von den beiden Eingängen E1 und E2 führen jeweils Leiterbahnen 58g bzw. 58h zu den ebenfalls auf dem Substrat angeordneten Gate-Widerständen 36; 38; 40 bzw. 44; 46; 48 (siehe Fig. 1 bzw. Fig. 2b), die hier als SMD-Bauteile (surface mounted device) ausgeführt sind. Von den Gate-Widerständen 36; 38; 40 bzw. 44; 46; 48 führt jeweils ein Bonddraht 72 zu den Steuereingängen G der MOSFETs.

Die Halbleiterschalter sind durch das Substrat 58 mit der Kühleinrichtung thermisch verbunden, die durch einen mit Kühlrippen versehenen Kühlkörper 66 gebildet ist. Der Kühlkörper 66 ist zur Kontaktierung einer Kühleinrichtung, zum Beispiel einer Fluidkühlung (Wasser, Öl, Luft oder dergl.) ausgestaltet.

Die Kondensatoranordnung überragt die Leiterschienen und / oder die Sammelschiene im vorliegenden Beispiel gar nicht. Es empfiehlt sich, dass die Kondensatoranordnung die Leiterschienen und / oder die Sammelschiene um nicht mehr als etwa 20 % bis etwa 30 % der Höhe der Kondensatoranordnung überragt. Damit wird erreicht, dass die Baugruppe eine Gesamthöhe hat, die sehr gering ist (minimal). Dies bewirkt eine sehr geringe Störstrahlung. Nicht zuletzt durch die Einfassung der Baugruppe mit den niedriges Potential (V_{SS}) führenden Leiterschienen 60, 62 sowie der ebenfalls niedriges Potential (V_{SS}) führenden Kühleinrichtung bzw. der mit ihr in Kontakt stehenden Potentialleitungsfläche 58f wird eine geringe Störstrahlung erreicht. Hinzu kommt, dass bei schnellen Schaltvorgängen induktiv hervorgerufene Störspitzen klein ausfallen, wenn, wie durch den vorliegenden Aufbau realisiert, die an dem Substrat angeordneten Bauteile, welche ein vom Potential der Potentialleitungsfläche unterschiedliches elektrisches Potential führen, mit der Potentialleitungsfläche 58f (und den Leiterschienen 60, 62) eine gedachte Querschnittsfläche einschließen, welche geringer ist als etwa die Hälfte der gedachten Querschnittsfläche, welche die Potentialleitungsfläche und die Leiterschienen miteinander umschließen.

Da die Kondensatoranordnung hier neben - und nicht wie im Stand der Technik üblich (siehe zum Beispiel DE 103 26 321 A1 über - den Halbbrücken angeordnet ist, hat die kapazitive Abstützung der Halbbrücken einen geringeren induktiven Anteil. Anstatt die Halbbrücken seitlich neben der Kondensatoranordnung anzuordnen, kann die Kondensatoranordnung auch unterhalb der Anordnung der Halbbrücken (auf der anderen Seite des Substrates), z. B. in den Kühlkörper und/oder das Substrat (auch teilweise eingelassen) angeordnet sein.

An einer von der Potentialleitungsfläche abliegenden Seite (also in Fig. 2b oben) kann an einer oder beider der Leiterschienen eine Baugruppe mit einem elektrischen Zwischenkreis zur Kopplung der Halbbrücken angeordnet sein, wobei der Zwischenkreis weitere Kondensatoren trägt. Diese Details sind hier nicht weiter veranschaulicht.

## Patentansprüche

1. Eine elektronische Baugruppe (10) zum Schalten elektrischer Leistung, mit
- zwei voneinander beabstandeten Leiterschienen (60, 62), die ein Substrat (58) auf einer von sich gegenüberliegenden Seiten des Substrats (58) jeweils übergreifen, wobei zwischen den Leiterschienen (60, 62) mittels eines Steuereingangs (E1, E2) anzusteuernde Halbleiterschälter (14, 16, 18, 22, 24, 26) zum Bereitstellen der elektrischen Leistung über eine Sammelschiene (64) an einem Leistungsausgang (A) angeordnet sind,
- zumindest eine Leiterbahn (58c, 58d), die ein von dem elektrischen Potential der Leiterschienen (60, 62) abweichendes elektrisches Potential aufweist,
- einer zwischen den beiden Leiterschienen (60, 62) angeordneten Kondensatoranordnung, wobei
- die Halbleiterschalter (14, 16, 18, 22, 24, 26) und die Leiterschienen (60, 62) und die Sammelschiene (64) mit an dem Substrat (58) aufgebrachten elektrischen Leitern (58a, 58b, 58c, 58d, 58e) verbunden sind,
- das Substrat (58) im Bereich wenigstens zweier seiner Ränder jeweils elektrische Leiter (58a, 58b) hat, die jeweils eine der Leiterschienen (60, 62) kontaktieren und im wesentlichen miteinander übereinstimmende elektrische Potentiale führen, wobei
- die Halbleiterschalter (14; 16, 18, 22, 24, 26) und die Sammelschiene (64) an einer Seite des Substrates (58) angeordnet sind und das Substrat (58) an der anderen Seite eine mit den Leiterschienen (60, 62) elektrisch verbundene Potentialleitung (58f) aufweist, wobei
- die Kondensatoranordnung auf der einen Seite des Substrats (58) oder auf der anderen Seite des Substrats (58) angeordnet ist.

2. Die elektronische Baugruppe (10) nach Anspruch 1, wobei die Kondensatoranordnung zwischen einer der Leiterschiehen (60, 62) und der Sammelschiene (64) angeordnet ist.

3. Die elektronische Baugruppe (10) nach einem der Ansprüche 1 bis 2, wobei eine der Leiterschienen zur anderen der Leiterschienen und / oder zur Sammelschiene (64) im wesentlichen parallel angeordnet ist.

4. Die elektronische Baugruppe (10) nach einem der Ansprüche 1 bis 3, wobei die Kondensatoranordnung (52a) sich zumindest teilweise über die Länge der Leiterschienen (60, 62) erstreckt und/oder die Leiterschienen (60, 62) und die Sammelschiene nicht oder um nicht mehr als etwa 20 % bis etwa 30 % der Höhe der Kondensatoranordnung (52a) überragt.

5. Die elektronische Baugruppe (10) nach einem der Ansprüche 1 bis 4, wobei die Potentialleitungsfläche (58f) eine Kühleinrichtung kontaktiert oder mit dieser integral ausgebildet ist.

6. Die elektronische Baugruppe (10) nach einem der Ansprüche 1 bis 5, wobei die Halbleiterschalter (14, 16, 18, 22, 24, 26) und mit den Halbleiterschaltern verbundene elektrische oder elektronische Bauteile (36, 38, 40, 44, 46, 48) so miteinander verschaltet sind, dass sie zwischen einer durch die Potentialleitungsfläche (58f) definierten Ebene und einer durch eine von der Potentialleitungsfläche (58f) abliegenden Seite der Leiterschienen (60, 62) und der Sammelschiene (64) definierten Ebene angeordnet sind.

7. Die elektronische Baugruppe (10) nach einem der Ansprüche 1 bis 6, wobei die Halbleiterschalter (14, 16, 18, 22, 24, 26) durch Feldeffekt-Transistoren (FETs) oder durch bipolare Transistoren mit isoliertem Gate-Anschluss (IGBTs) gebildet sind, wobei insbesondere MOS-FETs mit integrierten Freilaufdioden oder zu den Transistoren parallel geschaltete zusätzliche externe Freilaufdioden eingesetzt sind.

8. Die elektronische Baugruppe (10) nach einem der Ansprüche 1 bis 7, wobei die Halbleiter (14, 16, 18, 22, 24, 26) großflächige Kontaktierungsstellen mit einer Edelmetall-Auflage haben.

9. Die elektronische Baugruppe (10) nach einem der Ansprüche 1 bis 8, wobei an einer von der Potentialleitungsfläche (58f) abliegenden Seite einer oder beider der Leiterschiehen (60, 62) eine Baugruppe mit einem elektrischen Zwischenkreis zur Kopplung der Halbbrücken angeordnet ist, wobei der Zwischenkreis weitere Kondensatoren trägt.

10. Die elektronische Baugruppe (10) nach einem der Ansprüche 1 bis 9, wobei die Kondensatoranordnung Folienkondensatoren (52a, 52b, 52c) aufweist.

11. Die elektronische Baugruppe (10) nach einem der Ansprüche 1 bis 10, wobei bei einem gedachten Querschnitt, der beide Halbleiterschalter (14, 16, 18, 22, 24, 26) eines Halbleiterschalterpaares (14, 22; 16, 24; 18, 26) schneidet, eine erste gedachte Querschnittsfläche geringer ist als etwa die Hälfte einer zweiten gedachten Querschnittsfläche, wobei
- die erste gedachte Querschnittsfläche durch die Leitungsflächen (58c, 58d, 58e, 58g, 58h) welche ein vom Potential der Potentialleitungsfläche (58f) unterschiedliches elektrisches Potential führen und der Potentialleitungsfläche (58f) begrenzt ist, und
- die zweite gedachte Querschnittsfläche durch die Potentialleitungsfläche (58f) und eine durch die auf dem Substrat aufliegende Seite der Leiterschienen definierte Ebene begrenzt ist.

12. Die elektronische Baugruppe nach einem der Ansprüche 1 bis 11, wobei
- wenigstens zwei Halbleiterschalter (14, 22; 16, 24; 18, 26) unter Bildung einer Halbbrücke (12a, 12b, 12c) in Serie geschaltet sind;
- jeder Halbleiterschalter (14, 22; 16, 24, 18, 26) einen Steuereingang (G) zur Verbindung mit einer Ansteuereinrichtung aufweist;
- der erste Halbleiterschalter (14, 16, 18) mit seinem Drain-Anschluss (D) mit einem hohen Spannungspotential (V_{DD}) zu verbinden ist;
- der zweite Halbleiterschalter (22, 24, 26) mit seinem Source-Anschluss (S) mit einem niedrigen Spannungspotential (V_{SS}) zu verbinden ist;
- zur Bildung eines Ausgangs (A) der Source-Anschluss (S) jedes ersten Halbleiterschalters (14, 16, 18) mit dem Drain-Anschluss (D) des jeweiligen zweiten Halbleiterschalters (22, 24, 26) verbunden ist; und
- die wenigstens eine Kondensatoranordnung zwischen dem hohen und dem niedrigen Spannungspotential (V_{DD}, V_{SS}) angeordnet ist;
- jeweilige erste Halbleiterschalter (14, 16, 18) mit ihrem Drain-Anschluss (D) auf einem gemeinsamen ersten, mit dem hohen Spannungspotential (V_{DD}) zu verbindenden metallischen Leiter (58d) angeordnet sind;
- jeweilige zweite Halbleiterschalter (22, 24, 26) mit ihrem Drain-Anschluss (D) auf einem gemeinsamen zweiten, den Ausgang (A) bildenden metallischen Leiter (58c) angeordnet sind, wobei der zweite Leiter (58c) im Abstand zum ersten Leiter (58d) neben diesem gangeordnet ist;
- jeder zweite Halbleiterschalter (22, 24, 26) mit seinem Source-Anschluss (S) mit einem gemeinsamen dritten, mit dem niedrigen Spannungspotential (V_{SS}) zu verbindenden metallischen Leiter (58b) verbunden ist, der im Abstand zu und neben dem ersten und dem zweiten Leiter (58c, 58d) angeordnet ist.

13. Leistungsendstufe einer Ansteuereinrichtung für eine mehrphasige elektrische Maschine, wobei für jede Phase der elektrischen Maschine wenigstens eine elektronische Baugruppe (10) nach einem der vorhergehenden Ansprüche bereitgestellt ist, und wobei die elektronischen Baugruppen (10) zumindest entlang eines Teils des Umfangs oder einer Stirnfläche der elektrischen Maschine angeordnet sind.

## Claims

1. An electronic assembly (10) for switching electric power, comprising
- two conductor bars (60, 62) spaced apart from each other, which each overlap a substrate (58) on one of each other opposing sides of the substrate (58), wherein between the conductor bars (60, 62) are arranged semiconductor switches (14, 16, 18, 22, 24, 26) to be driven by means of a control input (E1, E2) in order to provide the electric power via a bus bar (64) at a power output (A),
- at least one conductor track (58c, 58d), which has an electric potential differing from the electric potential of the conductor bars (60, 62),
- a capacitor arrangement arranged between the two conductor bars (60, 62),
- the semiconductor switches (14, 16, 18, 22, 24, 26) and the conductor bars (60, 62) and the bus bar (64) being connected to electric conductors (58a, 58b, 58c, 58d, 58e) deposited on the substrate (58),
- the substrate (58), in the region of at least two of its edges, having in each case electric conductors (58a, 58b) which contact in each case one of the conductor bars (60, 62) and carry electric potentials that substantially correspond to one another,
- the semiconductor switches (14, 16, 18, 22, 24, 26) and/or the bus bar (64) being arranged on one side of the substrate (58) and the substrate (58) having on the other side a potential conductor (58f) connected electrically to the conductor bars (60, 62), wherein
- the capacitor arrangement being arranged on one side of the substrate (58) or on the other side of the substrate.

2. The electronic assembly (10) according to Claim 1, the capacitor arrangement being arranged between one of the conductor bars (60, 62) and the bus bar (64).

3. The electronic assembly (10) according to one of Claims 1 to 2, one of the conductor bars being arranged substantially parallel to the other of the conductor bars and/or to the bus bar (64).

4. The electronic assembly (10) according to one of Claims 1 to 3, the capacitor arrangement (52a) extending at least partly over the length of the conductor bars (60, 62) and/or not projecting, or projecting by not more than approximately 20% to approximately 30% of the height of the capacitor arrangement (52a), above the conductor bars (60, 62) and the bus bar.

5. The electronic assembly (10) according to one of Claims 1 to 4, the potential-conducting surface (58f) contacting a cooling device or being formed integrally therewith.

6. The electronic assembly (10) according to one of Claims 1 to 5, the semiconductor switches (14, 16, 18, 22, 24, 26) and electrical or electronic components (36, 38, 40, 44, 46, 48) connected to the semiconductor switches being connected up to one another in such a way that they are arranged between a plane defined by the potential-conducting surface (58f) and a plane defined by a side, of the conductor bars (60, 62) and of the bus bar (64), which is remote from the potential-conducting surface (58f).

7. The electronic assembly (10) according to one of Claims 1 to 6, the semiconductor switches (14, 16, 18, 22, 24, 26) being formed by field effect transistors (FETs) or by bipolar transistors with insulated gate terminal (IGBTs), and, in particular, MOSFETs with integrated free-wheeling diodes or with additional external free-wheeling diodes which are connected in parallel with the transistors are employed.

8. The electronic assembly (10) according to one of Claims 1 to 7, the semiconductors (14, 16, 18, 22, 24, 26) having large-area contacting points with a noble metal coating.

9. The electronic assembly (10) according to one of Claims 1 to 8, an assembly with an electric intermediate circuit for coupling the half-bridges being arranged on a side of one or both of the conductor bars (60, 62) which is remote from the potential-conducting surface (58f), the intermediate circuit carrying further capacitors.

10. The electronic assembly (10) according to one of Claims 1 to 9, the capacitor arrangement having film capacitors (52a, 52b, 52c).

11. The electronic assembly (10) according to one of Claims 1 to 10, in which, in an imaginary cross-section which intersects both semiconductor switches (14, 16, 18, 22, 24, 26) of a semiconductor switch pair (14, 22; 16, 24; 18, 26), a first imaginary cross-sectional area is less than approximately half of a second imaginary cross-sectional area,
- the first imaginary cross-sectional area being bounded by the conducting surfaces (58c, 58d, 58e, 58g, 58h) which carry an electric potential different from the potential of the potential-conducting surface (58f) and the potential-conducting surface (58f), and
- the second imaginary cross-sectional area being bounded by the potential-conducting surface (58f) and a plane defined by the side of the conductor bars which lies on the substrate.

12. The electronic assembly according to one of Claims 1 to 11,
- at least two semiconductor switches (14, 22; 16, 24; 18, 26) being connected in series with the formation of a half-bridge (12a, 12c, 12c);
- each of the semiconductor switches (14, 22; 16, 24, 18, 26) having a control input (G) for the connection to a driving device;
- the first semiconductor switch (14, 16, 18) having to be connected by its drain terminal (D) to a high voltage potential (V_{DD});
- the second semiconductor switch (22, 24, 26) having to be connected by its source terminal (S) to a low voltage potential (V_{SS});
- for forming an output (A), the source terminal (S) of each first semiconductor switch (14, 16, 18) being connected to the drain terminal (D) of the respective second semiconductor switch (22, 24, 26); and
- the at least one capacitor arrangement being arranged between the high and the low voltage potential (V_{DD}, Vss);
- respective first semiconductor switches (14, 16, 18) being arranged with their drain terminal (D) on a common first metallic conductor (58d) to be connected to the high voltage potential (V_{DD});
- respective second semiconductor switches (22, 24, 26) being arranged with their drain terminal (D) on a common second metallic conductor (58c) which forms the output (A), the second conductor (58c) being arranged spaced from and adjacent to the first conductor (58d);
- each second semiconductor switch (22, 24, 26) being connected by its source terminal (S) to a common third metallic conductor (58b) which is to be connected to the low voltage potential (V_{SS}) and is arranged spaced from and adjacent to the first and second conductor (58c, 58d).

13. Power output stage of a driving device for a multiphase electrical machine, at least one electronic assembly (10) according to one of the preceding claims being provided for each phase of the electrical machine, and the electronic assemblies (10) being arranged at least along a portion of the circumference or a face of the electrical machine.

## Revendications

1. Composant électronique (10) permettant la commutation d'une puissance électrique, comprenant
- deux rails conducteurs (60, 62) qui sont espacés l'un de l'autre et se trouvent respectivement en prise sur chacun des côtés opposés du substrat (58), des interrupteurs à semi-conducteurs (14, 16, 18, 22, 24, 26) destinés à être commandés au moyen d'une entrée de commande (E1, E2) étant disposés entre les rails conducteurs (60, 62) pour délivrer par l'intermédiaire d'un rail collecteur (64) la puissance électrique à une sortie de puissance (A),
- au moins une piste conductrice (58c, 58d) qui présente un potentiel électrique différent du potentiel électrique des rails conducteurs (60, 62),
- un ensemble condensateur disposé entre les deux rails conducteurs (60, 62),
- les interrupteurs à semi-conducteurs (14, 16, 18, 22, 24, 26) et les rails conducteurs (60, 62) et le rail collecteur (64) étant reliés à des conducteurs électriques (58a, 58b, 58c, 58d, 58e) montés sur le substrat (58),
- le substrat (58) possédant dans la zone d'au moins deux de ses bords des conducteurs électriques (58a, 58b) qui entrent respectivement en contact avec un des rails conducteurs (60, 62) et dans lesquels circulent des potentiels électriques sensiblement correspondants,
- les interrupteurs à semi-conducteurs (14, 16, 18, 22, 24, 26) et le rail collecteur (64) étant disposés sur une face du substrat (58) et le substrat (58) présentant sur l'autre face une surface conductrice de potentiel (58f) reliée électriquement aux rails conducteurs (60, 62),
- l'ensemble condensateur étant disposé sur l'une ou sur l'autre face du substrat (58)

2. Composant électronique (10) selon la revendication 1, l'ensemble condensateur étant disposé entre un des rails conducteurs (60, 62) et le rail collecteur (64).

3. Composant électronique (10) selon l'une des revendications 1 à 2, un des rails conducteurs étant disposé sensiblement parallèlement à l'autre des rails conducteurs et/ou au rail collecteur (64).

4. Composant électronique (10) selon l'une des revendications 1 à 3, l'ensemble condensateur (52a) s'étendant au moins partiellement sur la longueur des rails conducteurs (60, 62), et/ou les rails conducteurs (60, 62) et le rail collecteur ne dépassant pas la hauteur l'ensemble condensateur (52a) ou ne la dépassant pas de plus d'environ 20 % à environ 30 %.

5. Composant électronique (10) selon l'une des revendications 1 à 4, la surface conductrice de potentiel (58f) entrant en contact avec un dispositif de refroidissement ou étant formée d'un seul tenant avec celui-ci.

6. Composant électronique (10) selon l'une des revendications 1 à 5, les interrupteurs à semi-conducteurs (14, 16, 18, 22, 24, 26) et des composants (36, 38, 40, 44, 46, 48) électriques ou électroniques reliés aux interrupteurs à semi-conducteurs, étant connectés les uns aux autres de telle sorte qu'ils sont disposés entre un plan défini par la surface conductrice de potentiel (58f) et un plan défini par une face des rails conducteurs (60, 62) et du rail collecteur (64) opposée à la surface conductrice de potentiel (58f).

7. Composant électronique (10) selon l'une des revendications 1 à 6, les interrupteurs à semi-conducteurs (14, 16, 18, 22, 24, 26) étant constitués par des transistors à effet de champ (FETs) ou par des transistors bipolaires à grille isolée (IGBTs), plus particulièrement des MOS-FETs à diodes de roue libre intégrées ou des diodes de roue libre externes supplémentaires montées en parallèle par rapport aux transistors étant ici utilisés.

8. Composant électronique (10) selon l'une des revendications 1 à 7, les semi-conducteurs (14, 16, 18, 22, 24, 26) possédant des points de contact de grande dimension recouverts d'une couche de métal précieux.

9. Composant électronique (10) selon l'une des revendications 1 à 8, un composant pourvu d'un circuit électrique intermédiaire servant au couplage des demi-ponts étant disposé sur une face de l'un ou des deux rails conducteurs (60, 62) opposée à la surface conductrice de potentiel (58f), ledit circuit intermédiaire comportant des condensateurs supplémentaires.

10. Composant électronique (10) selon l'une des revendications 1 à 9, l'ensemble condensateur présentant des condensateurs à feuilles (52a, 52b, 52c).

11. Composant électronique (10) selon l'une des revendications 1 à 10, dans le cadre duquel, pour une section transversale imaginaire coupant les deux interrupteurs à semi-conducteurs (14, 16, 18, 22, 24, 26) d'une paire d'interrupteurs à semi-conducteurs (14, 22; 16, 24; 18, 26), une première surface de section transversale imaginaire est inférieure à environ la moitié d'une seconde surface de section transversale imaginaire,
- la première surface de section transversale imaginaire étant limitée par la surface conductrice de potentiel (58f) et par les surfaces conductrices (58c, 58d, 58e, 58g, 58h) dans lesquelles circulent un potentiel électrique différent du potentiel de la surface conductrice de potentiel (58f), et
- la seconde surface de section transversale imaginaire étant limitée par la surface conductrice de potentiel (58f) et par un plan défini par la face des rails conducteurs reposant sur le substrat.

12. Composant électronique (10) selon l'une des revendications 1 à 11,
- au moins deux interrupteurs à semi-conducteurs (14, 22; 16, 24; 18, 26) étant montés en série pour former un demi-pont (12a, 12b, 12c);
- chaque interrupteur à semi-conducteurs (14, 22; 16, 24; 18, 26) présentant une entrée de commande (G) destinée à être reliée à un dispositif de commande;
- le premier interrupteur à semi-conducteurs (14, 16, 18) devant être relié par l'intermédiaire de sa borne de drain (D) à un potentiel de tension élevé (V_{DD});
- le deuxième interrupteur à semi-conducteurs (22, 24, 26) devant être relié par l'intermédiaire de sa borne de source (S) à un potentiel de tension bas (V_{SS});
- la borne de source (S) de chaque premier interrupteur à semi-conducteurs (14, 16, 18) étant reliée à la borne de drain (D) du deuxième interrupteur à semi-conducteurs (22, 24, 26) correspondant pour former une sortie (A); et
- ledit au moins un ensemble condensateur étant disposé entre le potentiel de tension élevé et le potentiel de tension bas (V_{DD}, V_{SS});
- les premiers interrupteurs à semi-conducteurs (14, 16, 18) étant disposés avec leur borne de drain (D) sur un premier conducteur (58d) métallique commun à relier au potentiel de tension élevé (V_{DD});
- les deuxièmes interrupteurs à semi-conducteurs (22, 24, 26) étant disposés avec leur borne de drain (D) sur un deuxième conducteur (58c) métallique commun formant la sortie (A), le deuxième conducteur (58c) étant placé à distance du premier conducteur (58d), à côté de celui-ci;
- chaque deuxième interrupteur à semi-conducteurs (22, 24, 26) étant relié par l'intermédiaire de sa borne de source (S) à un troisième conducteur (58b) métallique commun à relier au potentiel de tension bas (V_{SS}), lequel conducteur est disposé à distance et à côté du premier et du deuxième conducteur (58c, 58d).

13. Etage final de puissance d'un dispositif de commande pour une machine électrique polyphasée, au moins un composant électronique (10) selon l'une des revendications précédentes étant fourni pour chacune des phases de la machine électrique, et les composants électroniques (10) étant disposés au moins le long d'une partie de la périphérie ou d'une face frontale de la machine électrique.
